# EUROPEAN PATENT SPECIFICATION

(11) **EP 4 408 943 B1**
(45) Date of publication and mention of the grant of the patent: **28.01.2026**
(21) Application number: 23821199.9
(22) Date of filing: 06.12.2023
(51) Int. Cl.: C09D 11/03, C09D 11/101, C09D 11/037, B41M 5/382, C23C 14/04, C23C 14/06, C23C 14/28

(54) **PRINTING PROCESS USING PARTICLES OF NON-AMORPHOUS CARBON ALLOTROPES**
DRUCKVERFAHREN MIT TEILCHEN AUS NICHTAMORPHEN KOHLENSTOFF-ALLOTROPEN
PROCÉDÉ D'IMPRESSION UTILISANT DES PARTICULES D'ALLOTROPES DU CARBONE NON AMORPHE

(30) Priority: 21.12.2022 EP 22215497
(43) Date of publication of application: 07.08.2024
(73) Proprietor: HELIOSONIC GmbH, 46483 Wesel (DE)
(72) Inventor: HINDERER, Florian, 46483 Wesel (DE); WALTER, Frank, 46483 Wesel (DE); ZIMMERMANN, Sara, 46483 Wesel (DE); MAY, Jörg, 46483 Wesel (DE); GANDOMKAR, Hooman, 46483 Wesel (DE)
(74) Representative: Kleine, Hubertus
(86) International application number: PCT/EP2023/084482
(87) International publication number: WO 2024/132526

(56) References cited:
- EP-A1- 3 333 230
- WO-A1-2011/154747
- PAPAZOGLOU S ET AL: "A study on the pulsed laser printing of liquid-phase exfoliated graphene for organic electronics", APPLIED PHYSICS A, SPRINGER BERLIN HEIDELBERG, BERLIN/HEIDELBERG, vol. 117, no. 1, 25 February 2014 (2014-02-25), pages 301 - 306, XP035392984, ISSN: 0947-8396, [retrieved on 20140225], DOI: 10.1007/S00339-014-8260-3
- WANG XINWEI ET AL: "Laser-induced forward transfer of graphene oxide", APPLIED PHYSICS A, vol. 127, no. 3, 25 February 2021 (2021-02-25), XP037381118, ISSN: 0947-8396, DOI: 10.1007/S00339-021-04356-5
- FERNÁNDEZ-PRADAS J. MARCOS ET AL: "Laser-Induced Forward Transfer: A Method for Printing Functional Inks", vol. 10, no. 8, 29 July 2020 (2020-07-29), CH, pages 651, XP093049668, ISSN: 2073-4352, Retrieved from the Internet <URL:http://dx.doi.org/10.3390/cryst10080651> DOI: 10.3390/cryst10080651

## Description

The invention relates to a printing process, a printing assembly, a substrate and the use of an ink layer.

A process for printing a substrate in which drops of ink are thrown from an ink-coated carrier onto a substrate to be printed is known from US 6,241,344 B1. To transfer the ink, energy is introduced through the carrier into the ink on the carrier at the position at which the substrate is to be printed. This causes vaporization of a part of the ink, or of a liquid present in the ink, and so the ink parts from the carrier. As a result of the pressure of the vaporizing ink, the drop of ink thus parted is thrown onto the substrate.

By introducing the energy in a directed way it is possible hereby to transfer the ink onto the substrate in accordance with a pattern to be printed. The energy needed to transfer the ink is introduced, for example, by a laser.

The carrier bearing the applied ink is, for example, a circulating ribbon, to which ink is applied by means of an application device before the printing region. The laser is located in the interior of the circulating ribbon, and so the laser acts on the carrier on the side facing away from the ink. Application of the ink to the ink carrier is accomplished, for example, by a roll which is immersed in an ink reservoir. A printing machine of this kind is also known from US 5,021,808 A.

In accordance with the teaching of this document as well, ink is applied from a reservoir container, using an application device, to a circulating ribbon, there being situated within the circulating ribbon a laser by means of which the ink is vaporized at mandated positions and is thrown accordingly onto the substrate to be printed. The ribbon in this case is made of a material transparent to the laser. For targeted vaporization of the ink it is possible for the circulating ribbon to be coated with an absorption layer, in which the laser light is absorbed and is converted into heat, and so the ink is vaporized at the position of exposure to the laser.

When the methods described above are used to transfer liquid ink by means of a laser to an opposing substrate (lift printing technologies), the result will generally be an undefined "spot" with numerous neighbouring satellites (splashes). Furthermore, a great deal of energy is needed in order to part the drop from the ink-bearing layer on the ink belt and then to convey it in free flight onto the opposite substrate. Because of this it is necessary - especially in order to achieve printing speeds that are acceptably high - to use very powerful lasers, thus increasing the costs and limiting the possible applications.

Furthermore, it is known through US20050212888 that by using small, laser-absorbing particles it is possible to boost the efficiency of the laser-induced printing process. This is important in that it allows a significant increase in the productivity of the process described.

One disadvantage when using absorption particles is that these particles very often also absorb in the visible wavelength spectrum, resulting in a more or less strong discoloration of the ink (liquid ink) that is to be printed.

WO 2019/175056 deals with a (lift) printing technology using an ink printing apparatus which is working as nozzleless droplet ejector for ejecting droplets of ink from the ink layer. In such a process a problem might be that the laser-induced ejection (drop flight) of the particles may be accompanied by emission of numerous disruptive satellites which deteriorates the quality of the printing result. However, WO 2019/145300 concerns an alternative (lift) printing mechanism according to which heat bulges are formed in the ink layer, wherein the bulges contact the substrate and wherein ink splitting is brought about by relative movement between substrate and ink carrier.

WO 2021047886 proposes to use reflective particles instead of carbon black (absorption) particles in a corresponding (lift technology) printing process. Such (appropriate) reflective particles have also absorbing properties in respect to the laser beam. In contrast to the typical carbon black absorbing particles these reflective (absorbing) particles may be more neutral for the coloured impression conveyed by the ink layer. Such reflective (absorbing) particles are typically of metal or of a metal-coated carrier material. However, these reflective particles have to be added in relative hight amounts (typically an amount of 1 - 10 wt.% to the ink that is used for the ink layer) in order to generate a sufficient (laser beam) absorbing effect. This generally causes a considerable loss of the transparency of the ink. Furthermore, such reflective particles typically generate a metallic sheen and/or a gray haze. This limits the suitability of this type of printing technology for many applications, especially for those where a high turbidity (and/or a gloss) is undesirable (e. g. for clear coats).

The problem addressed by the present invention is therefore to provide an universally applicable (lift) printing technology with which high print qualities can be achieved.

The object of the invention is achieved by a printing process in which a substrate to be printed is disposed opposite an ink carrier having a liquid ink layer and the liquid ink layer is irradiated regionally, wherein the liquid ink layer comprises a liquid and carbon containing particles X dispersed in the liquid, where said carbon containing particles X are present as carbon nanotube particles, graphite particles and/or structural analogue particles of graphite selected from the group consisting of graphene particles, graphene oxide particles, graphite oxide particles, fullerene particles and particles of graphite intercalation compounds, wherein the ink layer contains 0.02 - 0.40 wt.% of the carbon containing particles X dispersed in the liquid.

The printing process according to the invention enables the transfer of the ink according to a lift printing process. Ultimately, the absorption particles provided according to the invention ensure that a high absorption performance can still be achieved without causing any significant clouding of the ink: such a high degree of absorption efficiency generally means not only energy efficiency, but also has a direct effect on an attractive appearance of the printed result. This is particularly relevant in connection with chromatic printing, light printing, transparent printing and glossy printing, since undesirable haze can be avoided.

It is an economic advantage that only small dosages of said absorption particles were needed for the lift of the printing ink.

This is in contrast to known - lift technology used - absorption particles, such as carbon black or metallic particles which are also not substantially neutral for the coloured impression conveyed by the ink layer.

According to a preferred embodiment the printing process is performed by means of an ink printing apparatus where the ink layer is irradiated regionally in such a way that
a) heat bulges are formed in the ink layer which cause the splitting of ink droplets so that the ink printing apparatus is working as nozzleless droplet ejector for ejecting droplets of ink from the ink layer and/or
b) heat bulges are formed in the ink layer, wherein the bulges contact the substrate and wherein ink splitting is brought about by relative movement between substrate and ink carrier.

Nozzleless droplet ejection means that no ink nozzles are used according to the relevant printing mechanism.

Typically, the ink layer is irradiated regionally by means of a laser, more particularly by means of a switched laser.

Preferably, the ink carrier and ink layer are moved parallel to one another (especially lying on top of each other).

Typically, substrate and ink carrier are moved relative to one another at a speed which corresponds at least to the printing speed, preferably at least double the printing speed.

The ink layer contains 0.02 - 0.40 wt.% of the carbon containing particles X dispersed in the liquid.

This special small (relative quantitative) range of carbon containing particles X dispersed in the liquid guarantees on the one hand a sufficient (laser) absorption but on the other hand avoids undesirable haze. Furthermore, corresponding higher wt.% values than about 0.4 wt.% often cause undesired high viscosities of the ink (the thickening effect should be limited in order to maintain a good printability). It is also possible to use corresponding mixtures of particle X types; e. g. a mixture of carbon nanotube particles, graphite particles and graphene particles.

Generally, it is advantageous (also energy efficient) to reduce the used laser power (if possible).

Normally, the ink layer contains 10 - 99 wt.%, preferably 15 - 95 wt.%, more preferably 50 - 90 wt.% of the liquid.

Generally preferred are carbon nanotube particles, graphite particles and/or structural analogue particles of graphite selected from the group consisting of graphene particles, graphene oxide particles and graphite oxide particles.

More preferred are carbon nanotube particles, graphite particles and/or structural analogue particles of graphite selected from the group consisting of graphene particles.

Typically, at least 50 wt.% of all carbon containing particles dispersed in the liquid are present as carbon nanotube particles, graphite particles and/or graphene particles.

Most preferred are graphite particles and/or structural analogue particles of graphite selected from the group consisting of graphene particles.

Normally, particles X with a relatively small size (about < 5 µm) and a relatively small size distribution were used.

In case transparency is not needed, larger particles X with a broader particle size distribution can also be used.

Preferably, the liquid contains or consists of water and/ or organic solvents.

According to a special embodiment the liquid ink contains free radical polymerizable organic solvents (reactive thinners).

However, normally the ink layer contains polymers dispersed and/ or dissolved in the liquid.

Often, the ink layer comprises soluble polymer (as rheology modifier) having a weight average (Mw) molecular weight of greater than 250 000 g/mol, where the weight average (Mw) of the molecular weight of the soluble polymer is determined according to DIN 55672-2: 2016-3 (N,N-dimethyl acetamide is used as elution solvent).

The proportion of such soluble polymer is according to one embodiment of the invention 0.05 - 2 weight%, of the total ink mixture.

Such soluble polymer used according to one preferred embodiment of the invention comprises a cellulose ester, a cellulose nitrate, a cellulose ether, more particularly a hydroxypropylcellulose, a polyurethane or a vinyl polymer. Hydroxypropylcellulose in particular, in other words a cellulose ether in which some of the hydroxyl groups are linked as ethers with hydroxypropyl groups, appears particularly suitable for the effect of the invention.

However, it is possible to use conventional (organic or inorganic) binders - preferably conventional polymer binders.

According to a special embodiment the ink layer contains pigments.

According to a preferred embodiment the ink layer contains less than 0.4 wt.% carbon black, preferably no carbon black.

Often, the ink layer contains 0.1 - 80.0 wt.%, preferably 1.0 - 20.0 wt. % non-carbon particles with a diameter of 3 - 300 micrometer (measured by laser diffraction, according to DIN ISO 13220, edition 2020), preferably present as pigment particles.

Such large particles cannot be printed by conventional jetting (nozzles would block) but by the lift printing technology according to the present invention.

The invention is further directed to a printing assembly containing an ink layer as described above.

Additionally, the invention concerns the use of an ink layer as described above in a lift printing process.

Below the invention is further explained by using examples.

### Performed (Lift) printing process:

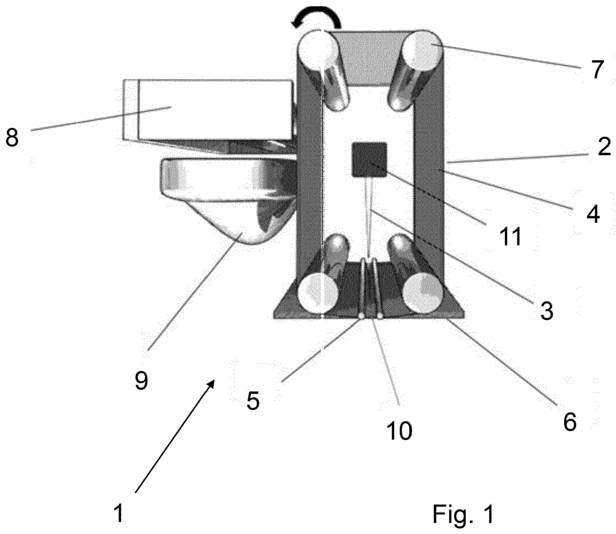

A printing apparatus, according to Fig. 1 was used.

Fig. 1 is a schematic view of one exemplary embodiment of a printing machine (1) which might be used to perform the process according to the invention.

The printing machine (printing apparatus) (1) comprises as ink carrier (4) a circulating ink ribbon.

The ink ribbon is coated homogeneously and over its full area with ink (2) by the inking unit (8). The ink ribbon subsequently moves in the arrow direction to the printing nip (10). The ink carrier (4) is distanced by a gap from the substrate (6) to be printed. Preferably the width of the gap is adjustable and/or is regulated continuously. This can be done by means, for example, of adaptable distancing rolls (5).

In the printing nip (10), using a laser scanner (11), a laser beam (3) is focused through the ink carrier (4), which is permeable to the laser light, into the ink (2). The local and targeted heating of parts of the ink (2) by means of the laser beam (3) causes explosive vaporization of a small region of the ink (2), and so a part of the printing ink (2) is transferred from the ink ribbon onto the opposite substrate (6).

The ink ribbon, controlled by the distancing rolls (5) and the deflection rollers (7), subsequently moves back in the direction of the inking unit (8). On contact between inking unit (8) and the ink ribbon, the ink (2) consumed is replenished.

The excess ink (2) in the inking unit (8) is collected in the ink trough (9) at the bottom and is added continuously in repetition to the printing operation.

### List of reference numerals relating to Fig. 1

1. Printing machine (printing apparatus)
2. Ink
3. Laser beam
4. Ink carrier
5. Distancing roll
6. Substrate
7. Deflection roller
8. Inking unit
9. Ink trough
10. Printing nip
11. Laser scanner

### Printing details and printing results:

To evaluate the LASER absorption efficiency, different concentrations of the carbon containing particles were added to a clear coat formulation (0.125 - 2.000 wt.-%) and each sample was printed on a transparent PET foil with a LASER power of 300 W and a printing speed of 2.5 m/min according to the standard LIFT printing process as described above.

In the next step, the coverage of the printed area (10 x 20 cm²) was evaluated visually under a digital light microscope ("Keyence VHX-7000"). The laser absorption and thus the ink transfer was sufficient when no unprinted (non-printed) areas were visible: this is meant with "full cover printing".

In additional pre-tests (simulation tests), the film transparency of the samples, depending on the particle concentration, was evaluated by applying films on a transparent PET foil via a wired K bar hand coater (close wound, 12 µm grooves). In this way it was possible to ensure that all samples have the same film thickness, which is a condition that the corresponding experiments were comparable with each other.

Based on the previous results of the pre-tests, print tests of the samples according to the standard LIFT process (as described above) were carried out, except in the case of aluminum particles, as the transparency was already insufficient at 0.500 wt.-%.

### K bar testing and printing results

Different carbon containing particles (and aluminum particles) have been incorporated into a solvent-based clear coat (dispersion) and applied on a transparent PET foil by the K bar to obtain a film with a thickness of about 6 µm after drying. This simulates the (substrate) result of a corresponding lift printing process according to the present invention (the results are comparable because this method provides the same film thickness). In other words: the film thickness after drying of the samples applied *via* K bar are comparable to printouts obtained by the LIFT process.

The visual result was evaluated: the light transmission of the corresponding films has been evaluated visually (providing a range between 0 and 6), where 0 represents transparent and 6 opaque.

All applied dispersions were prepared by standard dispersing procedures. The quality of the resulting dispersions is in accordance with commercially available standard dispersions.

| **Components of the Dispersion** | **[wt.-%]** |
|---|---|
| Polyvinylbutyrat (PVB), MOWITAL^{®} B 20 H | 6.000 |
| 3-methoxy-3-methyl butanol (MMB) | 90.000 - 94.000 |
| Dispersing agent (DISPERBYK^{®} 111, Phosphoric acid ester for aluminum; and DISPERBYK^{®}2013, polymer with quarternized amino groups for the other particles) | 0.050 - 1.000 |
| Particle (carbon containing particle/ or aluminum) | 0.125 - 2.000 |

The weight percentages in the table above are only approximate (since they do not always add up to 100 exactly); however, at least weight ratios are displayed.

### Special properties of the used particle types

| | **Graphene** | **Graphite** | **CNT** | **Carbon Black** | **aluminum** |
|---|---|---|---|---|---|
| Particle Size D₅₀ [µm] | 5-15 | < 5,5 | | < 1 | 10 |
| Surface Area [m²/g] | 400 - 600 | about 15 | 800 - 1600 | - | - |
| Length [µm] | about 10 | about 5 | > 5 | - | - |
| Diameter [nm] | - | - | 1.5 | - | - |

The graphene particles used in the experiments typically consist of 8 - 10 agglomerated ("singled out") layers (only for clarification: said layers are not agglomerated according to chemical graphite structure); The graphite particles used in the experiments (the corresponding layers agglomerated according to the chemical graphite structure) have an edge length of about 5 µm and a flake thickness of about 0.5 µm.

### Optical evaluation of the film based on kind of particle and particle concentration

| **[wt,.%]** | **Graphene** | **Graphite** | **CNT** | **Carbon Black** | **Aluminum** |
|---|---|---|---|---|---|
| 2.000 | 5 | 5 | - | 6 | 6 |
| | Printable | Printable | Printable | Printable | Printable |
| 1.000 | 4 | 4 | - | 6 | 6 |
| | Printable | Printable | Printable | Printable | Printable |
| 0.500 | 2 | 2 | 3 | 4 | 5 |
| | Printable | Printable | Printable | Hardly printable | Printing not tested |
| 0.250 | 1 | 1 | 1 | 1 | 4 |
| | Printable | Printable | Printable | Not printable | Printing not tested |
| 0.125 | 0 | 0 | 0 | 0 | 3 |
| | Printable | printable | printable | Not printable | Printing not tested |

| | | | | | |
|---|---|---|---|---|---|
| 0 = transparent, 6 = opaque | | | | | |

Printable (or not printable) via the Lift-Printing method as described above: "printable" stands for "full-cover printing"; "hardly printable" means that "full-cover printing" is not achieved.

For example, in the case of carbon black, it was even not possible to obtain a full-cover printing at concentrations below 0.500 wt.-%, even not at higher laser radiation power values.

For graphene, graphite and carbon nano tube (CNT) particles, concentrations of (and also below) 0.250 wt.-% were already sufficient even to obtain a full-cover printing with high transparency ("nearly transparent absorbers").

The results shown in the table above demonstrate the high efficiency of graphene, graphite and carbon nano tube particles as transparent (or nearly transparent) absorber materials for the LIFT process. In case said particles are used, a printing according to the present invention is even possible with particle concentrations below 0.250 wt.-%. For example, concentrations of about 0.01 wt.-% graphene particles might be sufficient even to obtain a full-cover printing. However, in case of such low particle concentrations used a corresponding high laser radiation power would be necessary in order to enable the printing process. However, in many cases such a high laser radiation power should be avoided (e. g. because saving of energy).

Particles of non-amorphous carbon particles typically contribute to a high viscosity. Especially, CNT particles (carbo nano tube particles) contribute to high viscosities (often also working as a kind of thickener). Depending on further influence parameters (like the viscosity of a used liquid) in many cases it is advantageous to limit the amount of CNT in order to reduce the thickening effect (an ink with a limited viscosity is normally easier to print).

## Claims

1. A printing process in which a substrate to be printed is disposed opposite an ink carrier having a liquid ink layer and the liquid ink layer is irradiated regionally, wherein the liquid ink layer comprises a liquid and carbon containing particles X dispersed in the liquid, where said carbon containing particles X are present as carbon nanotube particles, graphite particles and/or structural analogue particles of graphite selected from the group consisting of graphene particles, graphene oxide particles, graphite oxide particles, fullerene particles and particles of graphite intercalation compounds, wherein the ink layer contains 0.02 - 0.40 wt.% of the carbon containing particles X dispersed in the liquid.

2. A printing process according to claim 1, which is performed by means of an ink printing apparatus where the ink layer is irradiated regionally in such a way that
a) heat bulges are formed in the ink layer which cause the splitting of ink droplets so that the ink printing apparatus is working as nozzleless droplet ejector for ejecting droplets of ink from the ink layer and/or
b) heat bulges are formed in the ink layer, wherein the bulges contact the substrate and wherein ink splitting is brought about by relative movement between substrate and ink carrier.

3. A printing process according to claim 1 or 2, where the ink layer is irradiated regionally by means of a laser, more particularly by means of a switched laser.

4. A printing process according to one of the claims 1 - 3, where ink carrier and ink layer are moved parallel to one another

5. A printing process according to one of the claims 1 - 4, where substrate and ink carrier are moved relative to one another at a speed which corresponds at least to the printing speed, preferably at least double the printing speed.

6. A printing process according to one of the claims 1 - 5, wherein the ink layer contains 10 - 99 wt.%, preferably 15 - 95 wt.%, more preferably 50 - 90 wt.% of the liquid.

7. A printing process according to one of the claims 1 - 6, where at least 50 wt.% of all carbon containing particles dispersed in the liquid are present as carbon nanotube particles, graphite particles and/or graphene particles.

8. A printing process according to one of the claims 1 - 7, where the liquid contains or consists of water and/ or organic solvents.

9. A printing process according to one of the claims 1 - 8, where the liquid ink contains free radical polymerizable organic solvents.

10. A printing process according to one of the claims 1 - 9, where the ink layer contains polymers dispersed and/ or dissolved in the liquid.

11. A printing process according to one of the claims 1 - 10, where the ink layer contains pigments.

12. A printing process according to one of the claims 1 - 11, where the ink layer contains less than 0.4 wt.% carbon black, preferably no carbon black.

13. A printing process according to one of the claims 1 - 12, where the ink layer contains
0.1 - 80.0 wt.%, preferably 1.0 - 20.0 wt. % non-carbon particles with a diameter of 3 - 300 micrometer (measured by laser diffraction, according to DIN ISO 13220, edition 2020), preferably present as pigment particles.

14. A printing assembly containing an ink layer as described in one of the claims 1 - 13.

15. Use of an ink layer as described in one of the claims 1 - 13 in a printing process according to one of the claims 1 - 13.

## Patentansprüche

1. Druckverfahren, bei dem ein zu bedruckendes Substrat gegenüber einem Tintenträger mit einer flüssigen Tintenschicht angeordnet ist und die flüssige Tintenschicht bereichsweise bestrahlt wird, wobei die flüssige Tintenschicht eine Flüssigkeit und in der Flüssigkeit dispergierte kohlenstoffhaltige Partikel X umfasst, wobei die kohlenstoffhaltigen Partikel X als Kohlenstoffnanoröhrenpartikel, Graphitpartikel und/oder strukturell analoge Partikel mit Graphit sind, die aus der Gruppe bestehend aus Graphenpartikeln, Graphenoxidpartikeln, Graphitoxidpartikeln, Fullerene-Partikeln und Partikeln von Graphiteinlagerungsverbindungen ausgewählt sind, wobei die Tintenschicht 0,02 bis 0,40 Gew.-% der in der Flüssigkeit dispergierten kohlenstoffhaltigen Partikel X enthält.

2. Ein Druckverfahren gemäß Anspruch 1, das mittels einer Tintendruckvorrichtung durchgeführt wird, wobei die Tintenschicht bereichsweise so bestrahlt wird, dass
a) in der Tintenschicht Wärmeausbeulungen gebildet werden, die das Aufspalten von Tintentröpfchen bewirken, so dass die Tintendruckvorrichtung als düsenloser Tröpfchenauswerfer zum Auswerfen von Tintentröpfchen aus der Tintenschicht arbeitet, und/oder
b) in der Tintenschicht Wärmeausbeulungen gebildet werden, wobei die Ausbeulungen das Substrat berühren und wobei die Tintenaufspaltung durch eine Relativbewegung zwischen Substrat und Tintenträger bewirkt wird.

3. Druckverfahren nach Anspruch 1 oder 2, wobei die Tintenschicht mittels eines Lasers, insbesondere mittels eines geschalteten Lasers, bereichsweise bestrahlt wird.

4. Druckverfahren nach einem der Ansprüche 1 bis 3, wobei Tintenträger und Tintenschicht parallel zueinander bewegt werden.

5. Druckverfahren nach einem der Ansprüche 1 bis 4, wobei Substrat und Tintenträger relativ zueinander mit einer Geschwindigkeit bewegt werden, die mindestens der Druckgeschwindigkeit entspricht, vorzugsweise mindestens der doppelten Druckgeschwindigkeit.

6. Druckverfahren nach einem der Ansprüche 1 bis 5, wobei die Farbschicht 10 bis 99 Gew.-%, vorzugsweise 15 bis 95 Gew.-%, noch bevorzugter 50 bis 90 Gew.-% der Flüssigkeit enthält.

7. Druckverfahren nach einem der Ansprüche 1 bis 6, wobei mindestens 50 Gew.-% aller in der Flüssigkeit dispergierten kohlenstoffhaltigen Partikel als Kohlenstoffnanoröhrenpartikel, Graphitpartikel und/oder Graphenpartikel vorliegen.

8. Druckverfahren nach einem der Ansprüche 1 bis 7, wobei die Flüssigkeit Wasser und/oder organische Lösungsmittel enthält oder daraus besteht.

9. Ein Druckverfahren gemäß einem der Ansprüche 1 bis 8, wobei die flüssige Tinte radikalisch polymerisierbare organische Lösungsmittel enthält.

10. Ein Druckverfahren gemäß einem der Ansprüche 1 bis 9, wobei die Tintenschicht in der Flüssigkeit dispergierte und/oder gelöste Polymere enthält.

11. Ein Druckverfahren gemäß einem der Ansprüche 1 bis 10, wobei die Tintenschicht Pigmente enthält.

12. Druckverfahren nach einem der Ansprüche 1 bis 11, wobei die Tintenschicht weniger als 0,4 Gew.-% Ruß und vorzugsweise keinen Ruß enthält.

13. Druckverfahren nach einem der Ansprüche 1 bis 12, wobei die Tintenschicht 0,1 bis 80,0 Gew.-%, vorzugsweise 1,0 bis 20,0 Gew.-%, Nicht-KohlenstoffPartikel mit einem Durchmesser von 3 bis 300 Mikrometer (gemessen durch Laserbeugung gemäß DIN ISO 13220, Ausgabe 2020) enthält, vorzugsweise als Pigmentpartikel.

14. Druckvorrichtung, die eine Tintenschicht gemäß einem der Ansprüche 1 bis 13 enthält.

15. Verwendung einer Tintenschicht wie beschrieben in einem der Ansprüche 1 bis 13 in einem Druckverfahren gemäß einem der Ansprüche 1 bis 13.

## Revendications

1. Procédé d'impression dans lequel un substrat à imprimer est disposé en face d'un support d'encre comportant une couche d'encre liquide et la couche d'encre liquide est irradiée par région, dans lequel la couche d'encre liquide comprend un liquide et des particules X contenant du carbone dispersées dans le liquide, lesdites particules X contenant du carbone étant présentes sous forme de particules de nanotubes de carbone, de particules de graphite et/ou de particules analogues au graphite sur le plan structurel, choisies dans le groupe consistant en des particules de graphène, des particules d'oxyde de graphène, des particules d'oxyde de graphite, des particules de fullerène et des particules de composés d'intercalation de graphite, dans lequel la couche d'encre contient 0,02 à 0,40 % en poids des particules X contenant du carbone dispersées dans le liquide.

2. Procédé d'impression selon la revendication 1, qui est mis en œuvre au moyen d'un appareil d'impression à encre où la couche d'encre est irradiée par région de telle manière que
a) des renflements thermiques sont formés dans la couche d'encre, lesquels provoquent la séparation de gouttelettes d'encre, de sorte que l'appareil d'impression à encre fonctionne comme un éjecteur de gouttelettes sans buse pour éjecter des gouttelettes d'encre à partir de la couche d'encre et/ou
b) des renflements thermiques sont formés dans la couche d'encre, dans lequel les renflements entrent en contact avec le substrat et dans lequel la séparation de l'encre est provoquée par un mouvement relatif entre le substrat et le support d'encre.

3. Procédé d'impression selon la revendication 1 ou 2, dans lequel la couche d'encre est irradiée par région au moyen d'un laser, plus particulièrement au moyen d'un laser commuté.

4. Procédé d'impression selon l'une des revendications 1 à 3, dans lequel le support d'encre et la couche d'encre sont mis en mouvement parallèlement l'un à l'autre.

5. Procédé d'impression selon l'une des revendications 1 à 4, dans lequel le substrat et le support d'encre sont mis en mouvement l'un par rapport à l'autre à une vitesse qui correspond au moins à la vitesse d'impression, de préférence au moins au double de la vitesse d'impression.

6. Procédé d'impression selon l'une des revendications 1 à 5, dans lequel la couche d'encre contient 10 à 99 % en poids, de préférence 15 à 95 % en poids, plus préférentiellement 50 à 90 % en poids du liquide.

7. Procédé d'impression selon l'une des revendications 1 à 6, dans lequel au moins 50 % en poids de toutes les particules contenant du carbone dispersées dans le liquide sont présentes sous forme de particules de nanotubes de carbone, de particules de graphite et/ou de particules de graphène.

8. Procédé d'impression selon l'une des revendications 1 à 7, dans lequel le liquide contient ou consiste en de l'eau et/ou des solvants organiques.

9. Procédé d'impression selon l'une des revendications 1 à 8, dans lequel l'encre liquide contient des solvants organiques polymérisables par radicaux libres.

10. Procédé d'impression selon l'une des revendications 1 à 9, dans lequel la couche d'encre contient des polymères dispersés et/ou dissous dans le liquide.

11. Procédé d'impression selon l'une des revendications 1 à 10, dans lequel la couche d'encre contient des pigments.

12. Procédé d'impression selon l'une des revendications 1 à 11, dans lequel la couche d'encre contient moins de 0,4 % en poids de noir de carbone, de préférence ne contient pas de noir de carbone.

13. Procédé d'impression selon l'une des revendications 1 à 12, dans lequel la couche d'encre contient
0,1 à 80,0 % en poids, de préférence 1,0 à 20,0 % en poids, de particules non carbonées ayant un diamètre de 3 à 300 micromètres (mesuré par diffraction laser, selon la norme DIN ISO 13220, édition 2020), de préférence présentes sous forme de particules de pigment.

14. Ensemble d'impression contenant une couche d'encre telle que décrite dans l'une des revendications 1 à 13.

15. Utilisation d'une couche d'encre telle que décrite dans l'une des revendications 1 à 13 dans un procédé d'impression selon l'une des revendications 1 à 13.
